# EUROPEAN PATENT APPLICATION

(11) **EP 4 422 381 A1**
(43) Date of publication of application: **28.08.2024**
(21) Application number: 22883212.7
(22) Date of filing: 30.08.2022
(51) Int. Cl.: H10N 30/87, B32B 7/023, B32B 7/025, B32B 27/00, C08J 5/18, C08J 7/04, H10N 30/045, H10N 30/06

(54) **TRANSPARENT CONDUCTIVE PIEZOELECTRIC FILM, TOUCH SCREEN, AND PRODUCTION METHOD FOR TRANSPARENT CONDUCTIVE PIEZOELECTRIC FILM**

(30) Priority: 22.10.2021 JP 2021173431
(71) Applicant: Kureha Corporation, Chuo-ku Tokyo 103-8552 (JP)
(72) Inventor: IMAJI, Makoto, Tokyo 103-8552 (JP)
(74) Representative: Zimmermann & Partner Patentanwälte mbB
(86) International application number: PCT/JP2022/032537
(87) International publication number: WO 2023/067900

(57) **Abstract**

It is an object to provide a conductive piezoelectric film having excellent transparency. The transparent conductive piezoelectric film (11) according to the present invention has a transmittance at a wavelength of 450 nm of 75% or greater, a transmittance at a wavelength of 550 nm of 85% or greater, and a piezoelectric constant d₃₃ of 5 pC/N to 40 pC/N, and includes a transparent electrode layer (4).

## Description

### TECHNICAL FIELD

The present invention relates to a transparent conductive piezoelectric film, a touch panel, and a method of producing a transparent conductive piezoelectric film.

### BACKGROUND ART

A touch panel is widely used as a device into which information can be input by touching a screen. In a touch panel, an input device transmitting light is arranged on a display device such as a liquid crystal panel. A representative type of the touch panel includes an electrostatic capacity-type touch panel that utilizes a change in electric capacity generated between the screen and a finger. In recent years, various types of electrostatic capacity-type touch panels have been devised which detect the amount of indentation when a touch panel is touched, in addition to touch position information. In such a touch panel, in order to detect the amount of indentation when the touch panel is touched, a conductive piezoelectric film is used in which a transparent conductive layer made of a metal oxide such as indium oxide containing tin oxide (tin-doped indium oxide, ITO) or zinc oxide is laminated on a piezoelectric film.

In the production process of a typical conductive film in which a base material is not a piezoelectric film, a technique is known in which a metal oxide layer is crystallized by an annealing treatment (for example, see Patent Document 1). By the annealing treatment, the transmittance in the short wavelength region of visible light is increased, the transparency of the conductive film is improved, the yellow coloration is suppressed, and the surface resistance value is decreased, and consequently, the conductivity can be increased.

### CITATION LIST

### PATENT DOCUMENT

Patent Document 1: JP 2017-074792 A

### SUMMARY OF INVENTION

### TECHNICAL PROBLEM

However, the piezoelectric film has lower heat resistance than the base materials of other conductive films, and thus, the yellow coloration may become more remarkable by the annealing treatment. In order to obtain a conductive piezoelectric film having sufficient conductivity without the annealing treatment, it is necessary to increase the thickness of the metal oxide layer. However, when the thickness of an insufficiently crystallized metal oxide layer increases, the conductive piezoelectric film tends to have significantly decreased transparency and develop strong yellow coloration. When such a conductive piezoelectric film that is yellow-colored and has insufficient transparency is used as a component of an input device of a touch panel, it may be difficult to accurately express color development in a display device arranged under the input device.

It is an object of one aspect of the present invention to realize a conductive piezoelectric film having excellent transparency.

### SOLUTION TO PROBLEM

In order to solve the above-described problems, a transparent conductive piezoelectric film according to one aspect of the present invention is a transparent conductive piezoelectric film having a transmittance at a wavelength of 450 nm of 75% or greater, a transmittance at a wavelength of 550 nm of 85% or greater, and a piezoelectric constant d₃₃ of 5 pC/N to 40 pC/N, and including a transparent electrode layer, in which the transparent electrode layer has a surface resistance value of 50 Ω/sq or greater and less than 300 Ω/sq.

In order to solve the above-described problems, one aspect of a method of producing a transparent conductive piezoelectric film according to one aspect of the present invention is a method of producing a laminated film in which a first transparent coating layer, a second transparent coating layer, and a transparent electrode layer are stacked in this order on at least one surface of a transparent piezoelectric film, the method including a first step of producing the transparent piezoelectric film forming a film having a refractive index of 1.30 or greater and less than 1.45, a second step of forming the first transparent coating layer having a refractive index of 1.60 or greater and less than 1.80 on at least one surface of the transparent piezoelectric film, a third step of forming the second transparent coating layer having a refractive index of 1.30 or greater and less than 1.50 and a thickness of 10 nm to 70 nm on a surface of the first transparent coating layer, and a fourth step of forming the transparent electrode layer having a refractive index of 1.80 to 2.20 and a thickness of 20 nm or greater and less than 40 nm on a surface of the second transparent coating layer.

### ADVANTAGEOUS EFFECTS OF INVENTION

According to one aspect of the present invention, it is possible to realize a conductive piezoelectric film having excellent transparency.

### BRIEF DESCRIPTION OF THE DRAWINGS

FIG. 1 illustrates a transparent conductive piezoelectric film 11 according to one embodiment of the present invention.
FIG. 2 illustrates a transparent conductive piezoelectric film 12 according to one embodiment of the present invention.

### DESCRIPTION OF EMBODIMENTS

One embodiment of the present invention will be described in detail below.

### Transparent Conductive Piezoelectric Film

A transparent conductive piezoelectric film according to one embodiment of the present invention is a film in which a transparent electrode layer is provided on a piezoelectric film. In the transparent conductive piezoelectric film of the present embodiment, the transmittance at a wavelength of 450 nm is 75% or greater, the transmittance at a wavelength of 550 nm is 85% or greater, and a piezoelectric constant d₃₃ is from 5 pC/N to 40 pC/N. The transparent conductive piezoelectric film has excellent piezoelectric properties, transparency, and conductivity, and can be suitably used in a device such as a touch panel.

### Transmittance

In the transparent conductive piezoelectric film of the present embodiment, it is only required that the transmittance at a wavelength of 450 nm is 75% or greater, and the transmittance at a wavelength of 550 nm is 85% or greater. When the transmittances of the transparent conductive piezoelectric film at a wavelength of 450 nm and a wavelength of 550 nm are in the above-mentioned ranges, it is possible to provide a transparent conductive piezoelectric film with suppressed color tone and without turbidity. Therefore, the transparent conductive piezoelectric film can be suitably used in a device requiring transparency. For example, when the transparent conductive piezoelectric film is utilized in a device such as a touch panel, the transparent conductive piezoelectric film is transparent and thus does not hinder a display screen of the touch panel, which is preferable.

The transmittance at a wavelength of 450 nm is preferably 78% or greater and more preferably 80% or greater. The transparent conductive piezoelectric film of which the transmittance at a wavelength of 450 nm is in the above-mentioned range can be determined to be a film in which in particular a yellow tone is suppressed.

In the transparent conductive piezoelectric film, the transmittance at a wavelength of 550 nm is 85% or greater, and is preferably 87% or greater and more preferably 89% or greater. The transparent conductive piezoelectric film of which the transmittance at a wavelength of 550 nm is in the above-mentioned range can be determined to be a transparent conductive piezoelectric film that sufficiently transmits light and has high transparency when used in optical applications such as in a device.

In the transparent conductive piezoelectric film, it is only required that the transmittance at a wavelength of 450 nm and the transmittance at a wavelength of 550 nm are set so that a desired effect can be sufficiently achieved in the above-described case. For example, the transmittance at a wavelength of 450 nm and the transmittance at a wavelength of 550 nm may each be 97% or less. The transmittance at a wavelength of 450 nm and the transmittance at a wavelength of 550 nm are preferably as close to 100% as possible. Hereinafter, in the present specification, the term "transparency" refers to an optical characteristic evaluated by the transmittance at a wavelength of 450 nm and the transmittance at a wavelength of 550 nm, and "transparent" or "high transparency" refers to a state in which the transmittance at a wavelength of 450 nm is 75% or greater and the transmittance at a wavelength of 550 nm is 85% or greater.

### Piezoelectric Constant

It is only required that the piezoelectric constant d₃₃ of the transparent conductive piezoelectric film of the present embodiment is 5 pC/N or greater, preferably 8 pC/N or greater, and more preferably 10 pC/N or greater. Furthermore, it is only required that the piezoelectric constant d₃₃ of the transparent conductive piezoelectric film is 40 pC/N or less, preferably 30 pC/N or less, and more preferably 20 pC/N or less. Such a piezoelectric constant is achieved by the piezoelectric film included in the transparent conductive piezoelectric film.

The piezoelectric constant d₃₃ indicates a displacement of a voltage in a stress direction in response to an applied stress. When the piezoelectric constant d₃₃ increases, a voltage generated in response to the stress increases, which is preferable when the transparent conductive piezoelectric film is used in any device. In order to impart sufficient piezoelectric properties to the transparent conductive piezoelectric film, it is preferable that the piezoelectric constant d₃₃ is specifically not below the lower limit. From the viewpoint of the surface properties of the film, it is preferable that the piezoelectric constant d₃₃ specifically does not exceed the upper limit.

The transparent conductive piezoelectric film having such a piezoelectric constant d₃₃ is expected to be applied to a wide range of devices. For example, in the fields of acoustics, security, transportation, and medicine, the transparent conductive piezoelectric film is expected to be applied to sensors such as any types of pressure sensors and vibration sensors, switches, energy harvesting elements, and actuators. The transparent conductive piezoelectric film in which the range of the piezoelectric constant d₃₃ is in the above-mentioned range is particularly suitable for use in a touch panel.

### Transparent Electrode Layer

The transparent conductive piezoelectric film includes a transparent electrode layer. The transparent electrode layer is a structure that is transparent, conductive, and extends in a plane. The shape of the transparent electrode layer in a plan view may be appropriately selected depending on the application of the transparent conductive piezoelectric film. The transparent electrode layer will be described in detail in "Specific Examples of Transparent Conductive Piezoelectric Film".

The surface resistance value of the transparent conductive piezoelectric film may be determined according to an application. For example, in order to obtain a transparent conductive piezoelectric film having both high transparency and conductivity, the surface resistance value may be 50 Ω/sq or greater, 70 Ω/sq or greater, and further, 90 Ω/sq or greater. The surface resistance value may be less than 480 Ω/sq. When the surface resistance value is in the above-mentioned range, the transparent conductive piezoelectric film can be used as a film having conductivity in any device. The surface resistance value may be less than 300 Ω/sq. In a transparent conductive piezoelectric film of which the surface resistance value is in the above-mentioned range, the surface resistance value is low, and thus, the transparent conductive piezoelectric film can be suitably used in a device such as a touch panel, for example.

### Specific Examples of Transparent Conductive Piezoelectric Film

In order to obtain the transparent conductive piezoelectric film described above, the transparent conductive piezoelectric film may be a laminated film formed by stacking a plurality of layers of any type. The transparent conductive piezoelectric film is a laminated film having a structure in which a first transparent coating layer, a second transparent coating layer, and the transparent electrode layer are stacked in this order on at least one surface of a transparent piezoelectric film.

In the present embodiment, the expression "stacked in this order" refers to a state in which the layers are arranged adjacent to each other in the mentioned order in a laminate including the layers described above.

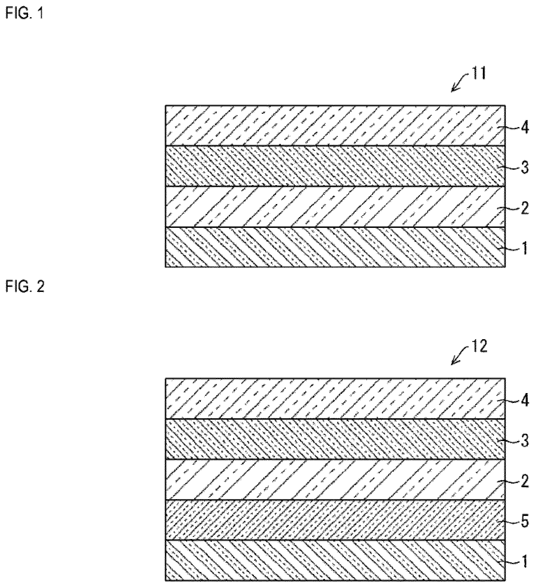

FIG. 1 illustrates a transparent conductive piezoelectric film 11 as an example of the transparent conductive piezoelectric film. The transparent conductive piezoelectric film 11 is a laminated film in which a first transparent coating layer 2, a second transparent coating layer 3, and a transparent electrode layer 4 are stacked in this order on one surface of a transparent piezoelectric film 1. The transparent conductive piezoelectric film 11 is not limited to the configuration illustrated in FIG. 1, and may further include another layer structure.

The transparent conductive piezoelectric film 11 may be a transparent conductive piezoelectric film in which the transparent piezoelectric film 1 and the first transparent coating layer 2 are stacked with the third transparent coating layer 5 sandwiched therebetween. That is, the transparent conductive piezoelectric film 11 may be a transparent conductive piezoelectric film that includes the third transparent coating layer 5 between the transparent piezoelectric film 1 and the first transparent coating layer 2. Such a transparent conductive piezoelectric film is illustrated as a transparent conductive piezoelectric film 12 in FIG. 2. The transparent conductive piezoelectric film 12 is a laminated film in which the third transparent coating layer 5, the first transparent coating layer 2, the second transparent coating layer 3, and the transparent electrode layer 4 are stacked in this order on one surface of the transparent piezoelectric film 1.

For example, in the transparent conductive piezoelectric film 11, the transparent piezoelectric film 1 has a refractive index of 1.30 or greater and less than 1.45, the first transparent coating layer 2 has a refractive index of 1.60 or greater and less than 1.80, the second transparent coating layer 3 has a refractive index of 1.30 to 1.50, and the transparent electrode layer 4 has a refractive index of 1.80 to 2.20. When the refractive index of each layer is in the above-mentioned range, the transparent conductive piezoelectric film 11 can be configured as a transparent conductive piezoelectric film having high transparency. In particular, when the refractive indices of the first transparent coating layer 2 and the second transparent coating layer 3 are in the above-mentioned ranges, the transmittance at a wavelength of 550 nm is improved.

When the transparent conductive piezoelectric film 11 is the transparent conductive piezoelectric film 12, the refractive index of the third transparent coating layer 5 may be 1.45 or greater and less than 1.60. The transparent conductive piezoelectric film 12 includes the third transparent coating layer 5, and thus the transparency can be improved.

In the present embodiment, the term "refractive index" refers to a refractive index at a wavelength of 589 nm.

The refractive indices of the first transparent coating layer 2 and the second transparent coating layer 3 are measured in conformity with JIS K7142. Specifically, each experimentally prepared coating layer is irradiated with measurement light having a wavelength of 589 nm and each layer is measured three times at 25.0 ± 1.0°C using an Abbe refractometer. The average of the measured values is calculated to obtain the refractive index.

In order to calculate the refractive index of the transparent electrode layer 4, psi (ψ) and delta (Δ) are measured by using a multiple-angle incidence high-speed spectroscopic ellipsometer (M-2000, available from J. A. Woollam Co.). The refractive index at a wavelength of 589 nm is calculated from psi (ψ) and delta (Δ).

The refractive index of the transparent piezoelectric film 1 is measured in conformity with ASTM D542.

In the transparent conductive piezoelectric film 11, the thickness of the second transparent coating layer 3 is from 10 nm to 70 nm, for example. Even though the refractive index of each layer is in the predetermined range, when the thickness of the second transparent coating layer 3 is outside the above-mentioned range, the transmittance at a wavelength of 450 nm may decrease, and a transparent conductive piezoelectric film having a yellow tone may be obtained. By setting the refractive index of each layer in the predetermined range and setting the thickness of the second transparent coating layer 3 in the above-mentioned range, it is possible to achieve high levels of transmittances both at a wavelength of 450 nm and at a wavelength of 550 nm in the transparent conductive piezoelectric film 11.

In the transparent conductive piezoelectric film 11, the thickness of the transparent electrode layer 4 is 13 nm or greater and less than 40 nm, for example. When the thickness of the transparent electrode layer 4 is in the above-mentioned range, the transparent conductive piezoelectric film 11 can be provided with a suitable surface resistance value and transparency.

Each layer in the transparent conductive piezoelectric film 11 and the transparent conductive piezoelectric film 12 will be described in detail below. In the transparent conductive piezoelectric film 11, the refractive index of each layer is set to a "more preferable" range described later, and thus, it is possible to obtain a transparent conductive piezoelectric film having higher transparency.

### Transparent Piezoelectric Film 1

The transparent piezoelectric film 1 included in the transparent conductive piezoelectric film 11 refers to a film that has piezoelectric properties and is transparent. Here, the term "transparent" in the transparent piezoelectric film 1 refers to a film having excellent transmittances at a wavelength of 450 nm and a wavelength of 550 nm. Specifically, the transmittance of the transparent piezoelectric film 1 at a wavelength of 450 nm may be 88% or greater, and is preferably 90% or greater. The transmittance of the transparent piezoelectric film 1 at a wavelength of 550 nm may be 89% or greater, and is preferably 91 % or greater.

For example, the refractive index of the transparent piezoelectric film 1 is 1.30 or greater and less than 1.45. It is only required that the refractive index of the transparent piezoelectric film 1 is in this range. However, the refractive index is preferably 1.34 or greater and more preferably 1.36 or greater. Furthermore, the refractive index of the transparent piezoelectric film 1 is preferably 1.44 or less and more preferably 1.43 or less.

In the present embodiment, the transparent piezoelectric film 1 is a film made of a resin. The resin in the present embodiment may be any resin, as long as the film has piezoelectric properties represented by the piezoelectric constant d₃₃, and the resin may be one type of resin or a combination of two or more types of resins. Examples of the resin satisfying the conditions described above include fluororesins, polyamide 11, cellulose, polyurethane, and polyurea.

Among the resins described above, the fluororesins are preferable. When the transparent piezoelectric film is made of a fluororesin, it is possible to obtain a transparent conductive piezoelectric film having excellent transparency and piezoelectric properties represented by the piezoelectric constant d₃₃. In the present embodiment, the expression "made of a fluororesin" in the embodiment means that the fluororesin is a main component in a composition constituting the transparent piezoelectric film. The expression that "fluororesin is a main component" means that the fluororesin is the largest component among the resin components in the composition. A content of the fluororesin in the composition is preferably 51 mass% or greater, more preferably 80 mass% or greater, and particularly preferably 100 mass%. That is, the transparent piezoelectric film 1 is particularly preferably a film made of a fluororesin.

Among the fluororesins, a vinylidene fluoride resin is preferable. Examples of the vinylidene fluoride resin include a homopolymer of vinylidene fluoride and a copolymer of vinylidene fluoride. The content of the structural unit derived from a monomer other than vinylidene fluoride in the copolymer of vinylidene fluoride may be appropriately determined within a range in which properties specific to the application of the transparent piezoelectric film can be obtained.

Examples of the monomer other than vinylidene fluoride in the copolymer of vinylidene fluoride include a hydrocarbon-based monomer and a fluorine compound. Examples of the hydrocarbon-based monomer include fluoromonomers such as vinyl fluoride (VF), trifluoroethylene (TrFE), tetrafluoroethylene (TeFE), hexafluoropropene (HFP), 1-chloro-1-fluoroethylene (1,1-CFE), 1-chloro-2-fluoro-ethylene (1,2-CFE), 1-chloro-2,2-difluoroethylene (CDFE), chlorotrifluoroethylene (CTFE), trifluorovinyl monomer, 1,1,2-trifluorobutene-4-bromo-1 -butene, 1,1,2-trifluorobutene-4-silane-1-butene, perfluoroalkyl vinyl ether, perfluoromethyl vinyl ether (PMVE), perfluoropropyl vinyl ether (PPVE), perfluoroacrylate, 2,2,2-trifluoroethyl acrylate, and 2-(perfluorohexyl)ethyl acrylate; and hydrocarbon-based monomers such as ethylene, propene, maleic anhydride, vinyl ether, vinyl ester, allyl glycidyl ether, acrylic acid-based monomer, methacrylic acid-based monomer, and vinyl acetate. Among these, trifluoroethylene, tetrafluoroethylene, and hexafluoropropene are preferable as the monomer other than vinylidene fluoride in the copolymer.

For example, the vinylidene fluoride copolymer may be a binary copolymer such as a vinylidene fluoride copolymer (VDF/TrFE) obtained by copolymerization of vinylidene fluoride and trifluoroethylene, a vinylidene fluoride copolymer (VDF/HFP) obtained by copolymerization of vinylidene fluoride and hexafluoropropene, and a vinylidene fluoride copolymer (VDF/TeFE) obtained by copolymerization of vinylidene fluoride and tetrafluoroethylene. The binary copolymer preferably has a mixing ratio of vinylidene fluoride to the comonomer from 50:50 to 90:10. For example, a vinylidene fluoride copolymer (VDF/TeFP) may be obtained by copolymerization of vinylidene fluoride and tetrafluoroethylene at a mixing ratio of 80:20. Furthermore, the vinylidene fluoride copolymer may be a ternary copolymer such as a vinylidene fluoride copolymer (VDF/TFE/HFP) obtained by copolymerization of vinylidene fluoride, trifluoroethylene, and hexafluoropropene at a mixing ratio of 40:40:20.

In the present embodiment, a homopolymer of vinylidene fluoride and a copolymer of vinylidene fluoride and tetrafluoroethylene are preferably used.

The transparent piezoelectric film in the present embodiment may contain various additives as long as the effect of the present embodiment can be achieved. The additive may be one or more types of additives, and examples thereof include a plasticizer, a lubricant, a crosslinking agent, a UV absorber, a pH controlling agent, a stabilizer, an antioxidant, a surfactant, and a pigment.

The thickness of the transparent piezoelectric film 1 in the present embodiment can be appropriately determined from a range in which the effect of the present embodiment can be achieved, depending on the application of the transparent conductive piezoelectric film 11. When the thickness of the transparent piezoelectric film 1 is too small, the mechanical strength of the film may be insufficient. When the thickness of the film is too large, the effect of the film may plateau or the transparency may be insufficient, and it may be difficult to use the transparent piezoelectric film 1 in an optical application. From this viewpoint, the thickness of the transparent piezoelectric film 1 may be 20 µm or greater, and is preferably 30 µm or greater and more preferably 35 µm or greater. Furthermore, the thickness of the transparent piezoelectric film 1 may be less than 200 µm, and is preferably 120 µm or less and more preferably 80 µm or less.

### Transparent Electrode Layer 4

The transparent electrode layer 4 in the present embodiment is a layered electrode stacked on the second transparent coating layer 3.

The transparent electrode layer 4 in the present embodiment has a structure that extends in a plane, is conductive, and sufficiently transparent, and can also be referred to as a transparent conductive layer. Even if a material constituting the transparent electrode layer 4 is not transparent, it is only required that the transparent electrode layer 4 exhibits sufficient transparency in a structure in which the transparent electrode layer 4 can exhibit its function. For example, the transparent electrode layer 4 may include a conductive component or composition having high transparency, or may include a conductive material not having transparency, but have a very thin or very fine structure capable of exhibiting sufficient transparency.

The transparent electrode layer 4 may be formed on a transparent substrate and bonded to the second transparent coating layer 3 together with the substrate. It is only required that the transparent electrode layer 4 is arranged on at least one surface side of the transparent piezoelectric film 1. When the first transparent coating layer 2 and the second transparent coating layer 3 are formed on both surface sides of the transparent piezoelectric film, it is only required that the transparent electrode layer 4 is arranged on the second transparent coating layer 3 on at least one side.

A material forming the transparent electrode layer 4 is not limited, and a metal oxide of at least one metal selected from the group consisting of In, Sn, Zn, Ga, Sb, Ti, Si, Zr, Mg, Al, Au, Ag, Cu, Pd, and W may be suitably used. As the metal oxide, ITO, zinc oxide, an antimony-tin composite oxide (ATO), or the like is preferably used, and ITO is particularly preferably used. The metal oxide may be doped with a metal atom indicated in the group described above, if necessary.

In order to avoid discoloration of the transparent piezoelectric film 1, it is necessary not to heat the transparent conductive piezoelectric film 11 in the present embodiment at high temperatures. Therefore, when the material of the transparent electrode layer 4 is a metal oxide, the metal oxide may be amorphous. The fact that the transparent electrode layer 4 is made of an amorphous material can be confirmed by an image observed by using a transmission electron microscope. In the present specification, a material in which crystals other than fine crystals are not observed is referred to as amorphous, and a material in which crystals are grown to such an extent that crystal grains are observed is referred to as crystalline.

The amorphous property in the transparent electrode layer 4 can be determined by utilizing an X-ray diffraction method. The amorphous property can be adjusted by the presence or absence and the degree of implementation of a step of promoting crystallization in the preparation of the transparent electrode layer 4, such as annealing after the transparent electrode layer 4 is formed.

In one embodiment, the transparent electrode layer 4 is formed of an indium-tin composite oxide. In still another aspect, the transparent electrode layer 4 is formed of an indium-tin composite oxide, and is in a state where a peak of the indium-tin composite oxide is not detectable by X-ray diffraction. According to such a configuration, it is possible to provide the transparent electrode layer 4 that is amorphous and further has a refractive index in a suitable range.

The refractive index of the transparent electrode layer 4 is from 1.80 to 2.20, for example. The refractive index of the transparent electrode layer 4 is not limited, as long as the refractive index is in this range, and is preferably 1.83 or greater, and more preferably 1.85 or greater. Furthermore, the refractive index of the transparent electrode layer 4 is preferably 2.00 or less and more preferably 1.94 or less.

In particular, the transparent conductive piezoelectric film including the transparent electrode layer 4 having a refractive index of 1.94 or less is a film produced without heating at high temperatures. Therefore, the transparency and the color tone of the transparent piezoelectric film 1 are not impaired by a high-temperature treatment, and a suitable transparent conductive piezoelectric film can be obtained. Especially, a transparent conductive piezoelectric film including the transparent electrode layer 4 that has a refractive index of 1.94 or less and further is amorphous is preferable.

On the other hand, when the material of the transparent electrode layer 4 is amorphous, the material itself is a material having a yellow tone. The transparent conductive piezoelectric film 11 including the transparent electrode layer 4 deposited tends to be a film having a color tone, even if other layers are transparent. However, similarly to the transparent conductive piezoelectric film 11 according to one embodiment of the present invention, by adjusting the refractive index of each layer, it is possible to realize the transparent conductive piezoelectric film 11 having suitable optical characteristics.

It is only required that the thickness of the transparent electrode layer 4 is 13 nm or greater. The thickness of the transparent electrode layer 4 is preferably 15 nm or greater and more preferably 20 nm or greater. When the thickness of the transparent electrode layer 4 is too small, the electrical resistance of the transparent conductive piezoelectric film 11 may increase, and a discontinuous portion may be formed in the transparent electrode layer 4. When the thickness of the transparent electrode layer 4 is not less than the lower limit mentioned above, it is possible to obtain the transparent conductive piezoelectric film 11 as a continuous coating film having good conductivity with a surface resistance value of less than 480 Ω/sq.

In particular, the thickness of the transparent electrode layer 4 is preferably 20 nm or greater. When the thickness of the transparent electrode layer 4 is 20 nm or greater, it is possible to obtain a more suitable transparent conductive piezoelectric film having a surface resistance value of less than 300 Ω/sq.

It is only required that the thickness of the transparent electrode layer 4 is less than 40 nm. The thickness of the transparent electrode layer 4 is preferably less than 38 nm and more preferably less than 35 nm. When the thickness of the transparent electrode layer 4 is too large, the transparency may decrease, for example. When the thickness of the transparent electrode layer 4 does not exceed the upper limit described above, the transparency of the transparent conductive piezoelectric film can be enhanced. The thickness of the transparent electrode layer 4 is determined by the following method in which the thickness is determined by observation of a cross section of the transparent conductive piezoelectric film 11.

The transparent conductive piezoelectric film is embedded in an epoxy resin, and the epoxy resin mass is cut to expose a cross section of the transparent conductive piezoelectric film. The exposed cross section of the transparent conductive piezoelectric film is observed by using a scanning electron microscope ("SU3800", available from Hitachi High-Tech Corporation) under conditions including an acceleration voltage of 3.0 kV and a magnification of 50000 times, to measure the thicknesses of the coating layers and the transparent electrode layer in the transparent conductive piezoelectric film.

In the measurement of the thicknesses of the coating layers and the transparent electrode layer, the thickness is measured at any two locations of each of the coating layers and the transparent electrode layer, and the average value of the measurement values obtained for each layer is used as the thickness of each layer. Under the observation conditions described above, an interface between the layers is observed and is a substantially smooth line. In this case, in the measurement of the thickness of each layer, the distance between the lines is measured.

As described above, the thickness of the transparent electrode layer 4 is important from the viewpoint of maintaining the conductivity and improving the transparency of the transparent conductive piezoelectric film 11. Furthermore, by a preferable combination of refractive indices and thicknesses of the first transparent coating layer, the second transparent coating layer, the transparent electrode layer, and the third transparent coating layer which is optionally provided in the transparent conductive piezoelectric film 11, interface reflection between the layers is suitably adjusted to cancel out interface reflection, and the transparency is further improved.

### First Transparent Coating Layer 2

The first transparent coating layer 2 in the present embodiment is a layer positioned between the transparent piezoelectric film 1 and the second transparent coating layer 3.

The refractive index of the first transparent coating layer 2 is 1.60 or greater and less than 1.80. The refractive index of the first transparent coating layer 2 is not limited, as long as the refractive index is in this range. The refractive index of the first transparent coating layer 2 is preferably 1.63 or greater and more preferably 1.65 or greater. Furthermore, the refractive index of the first transparent coating layer 2 is preferably 1.75 or less and more preferably 1.72 or less.

The material of the first transparent coating layer 2 may be appropriately selected from any usable materials, as long as the material satisfies such a refractive index. The material may be an inorganic material or an organic material, and a mixed material of an inorganic material and an organic material, or a composite material thereof may be used. The material may be one type of material, a mixed material including two or more types of materials, and a composite material. In order to improve the transparency of the transparent conductive piezoelectric film, it is preferable to use one type of material or a composite material further containing metal oxide particles described later. Further, the material of the coating layer may be a material of a hard coat layer. Examples of the material include a melamine resin, a urethane resin, a (meth)acrylic acid ester resin, a silane compound, and a metal oxide. The term "(meth)acrylic acid" is a generic term for acrylic acid and methacrylic acid, and means one or both of acrylic acid and methacrylic acid. In particular, the (meth)acrylic acid ester resin is preferable from the viewpoints of sufficient transparency, abundance of material types, and low raw material price.

The material of the first transparent coating layer 2 may include other materials required to form a transparent coating layer. As a material of a transparent coating layer made of a (meth)acrylate resin, a composition obtained by mixing an initiator, an oligomer, a monomer, and other components may be generally used. In this case, the physical properties of the transparent coating layer are mainly determined by the oligomer and the monomer. Examples of the oligomer include monofunctional and polyfunctional (meth)acrylates. Examples of the monomer mentioned above include urethane (meth)acrylate, epoxy (meth)acrylate, and polyester (meth)acrylate.

Metal oxide particles may be added to the above-described materials to adjust the refractive index of the first transparent coating layer 2. Examples of fine metal oxide particles in which the refractive index of the fine metal oxide particles is 1.50 or greater include aluminum oxide, titanium oxide, zirconium oxide, zinc oxide, and tin oxide, and among these, titanium oxide and zirconium oxide are preferable.

The first transparent coating layer 2 may further contain a material for achieving an optional function. For example, the first transparent coating layer 2 may contain an antistatic agent. Examples of the antistatic agent include surfactants, antimony pentoxide, indium-tin composite oxide (ITO), and conductive polymers.

The preferred thickness of the first transparent coating layer 2 depends on whether the third transparent coating layer 5 is included in the transparent conductive piezoelectric film. When the transparent conductive piezoelectric film 11 does not include the third transparent coating layer 5, the thickness of the first transparent coating layer 2 may be 400 nm or greater, and is preferably 450 nm or greater and more preferably 500 nm or greater. The thickness of the first transparent coating layer 2 may be less than 1300 nm, and is preferably 1000 nm or less and more preferably 800 nm or less.

In the transparent conductive piezoelectric film that does not include the third transparent coating layer 5, the first transparent coating layer not only needs to have a predetermined refractive index in order to enhance the transparency of the transparent conductive piezoelectric film, but also needs to prevent scratches and surface irregularities on the surface of the transparent piezoelectric film 1. When the thickness of the first transparent coating layer 2 is specifically not lower than the lower limit, scratches, surface irregularities, and the like on the surface of the transparent piezoelectric film 1 can be prevented, and thus, the transparency of the transparent piezoelectric film 1 increases. It is preferable that the thickness of the first transparent coating layer 2 specifically does not exceed the upper limit, to obtain a thin transparent piezoelectric film and enhance the transparency of the film.

In the transparent conductive piezoelectric film 12 that includes the third transparent coating layer 5, the thickness of the first transparent coating layer 2 may be 60 nm or greater, and is preferably 70 nm or greater and more preferably 83 nm or greater. The thickness of the first transparent coating layer 2 may be less than 300 nm, and is preferably 250 nm or less and more preferably 230 nm or less. When the thickness of the first transparent coating layer is in the above-mentioned range, transparency can be imparted to the transparent conductive piezoelectric film 11.

### Second Transparent Coating Layer 3

The second transparent coating layer 3 in the present embodiment is a layer positioned between the first transparent coating layer 2 and the transparent electrode layer 4.

The refractive index of the second transparent coating layer 3 is from 1.30 to 1.50, for example. It is only required that the refractive index of the second transparent coating layer 3 is in this range. The refractive index of the second transparent coating layer 3 is preferably 1.35 or greater and more preferably 1.37 or greater. The refractive index of the second transparent coating layer 3 is preferably 1.48 or less and more preferably 1.47 or less.

The material of the second transparent coating layer 3 may be appropriately selected from any usable materials, as long as the material satisfies such a refractive index. For example, the material may be appropriately selected from the materials mentioned as examples of the material of the first transparent coating layer 2, to obtain an appropriate refractive index. Furthermore, in order to adjust the refractive index, the material may contain silicon dioxide or one or more metal fluorides selected from the group consisting of NaF, Na₃AlF₆, LiF, MgF₂, CaF₂, and BaF₂. Among these, silicon dioxide is preferred.

Similarly to the material mentioned as the material of the first transparent coating layer 2, the material of the second transparent coating layer 3 may contain another material necessary for forming a transparent coating layer.

It is only required that the thickness of the second transparent coating layer 3 is from 10 nm to 70 nm. The thickness of the second transparent coating layer 3 is preferably 15 nm or greater and more preferably 20 nm or greater. The thickness of the second transparent coating layer 3 is preferably 68 nm or less and more preferably 65 nm or less. When the thickness of the second transparent coating layer 3 is in the above-mentioned range, the transparency and the color tone of the transparent conductive piezoelectric film 11 can be improved.

### Third Transparent Coating Layer 5

The third transparent coating layer 5 is a layer that is optionally provided on the transparent conductive piezoelectric film. When the third transparent coating layer 5 is provided, the third transparent coating layer 5 is a layer that directly contacts the transparent piezoelectric film 1. For example, similarly to the transparent conductive piezoelectric film 12, the third transparent coating layer 5 is a layer positioned between the transparent piezoelectric film 1 and the first transparent coating layer 2. When the first transparent coating layer 2 is provided only on one surface of the transparent piezoelectric film 1, the third transparent coating layer 5 may be provided on the other surface of the transparent piezoelectric film 1. The transparent conductive piezoelectric film 11 may include the third transparent coating layers 5 on both sides of the transparent piezoelectric film 1.

The refractive index of the third transparent coating layer 5 may be 1.45 or greater, and is preferably 1.48 or greater, and more preferably 1.50 or greater. The refractive index of the third transparent coating layer 5 may be less than 1.60, and is preferably less than 1.58, and more preferably less than 1.55. When the third transparent coating layer 5 is provided on at least one surface of the transparent piezoelectric film 1, it is possible to improve the transparency of the transparent conductive piezoelectric film 12.

The material of the third transparent coating layer 5 may be appropriately selected from any usable materials, as long as the material satisfies such a refractive index. For example, the material may be appropriately selected from the materials mentioned as examples of the material of the first transparent coating layer 2, to obtain an appropriate refractive index. The third transparent coating layer 5 may be a transparent surface protection layer for scratch prevention, also called a hard coat layer. It is preferable to use a material that achieves a suitable refractive index and further has excellent scratch resistance.

Furthermore, from the viewpoint of adhesiveness and prevention of films from blocking each other, inorganic particles, polymer beads, and the like may be added to the material of the third transparent coating layer 5. Examples of the inorganic particles include synthetic silica, talc, diatomaceous earth, calcium carbonate, feldspar, quartz, or the like. In particular, synthetic silica can be preferably used in order to obtain a plastic film having high quality. Examples of the synthetic silica include SiO₂.

The thickness of the third transparent coating layer 5 may be 500 nm or greater, and is preferably 700 nm or greater, and more preferably 900 nm or greater. When the thickness of the third transparent coating layer 5 is not less than the lower limit, an effect of protecting the transparent piezoelectric film 1 can be expected. The thickness of the third transparent coating layer 5 may be 1400 nm or less in order to obtain a thin film, and is preferably 1200 nm or less, and more preferably 1100 nm or less. When the thickness of the third transparent coating layer does not exceed the upper limit, it is possible to suppress a decrease in piezoelectric properties represented by the piezoelectric constant d₃₃. In addition, it is possible to suppress deterioration in quality such as cracks and curling of the transparent conductive piezoelectric film caused by heating in incorporation of the transparent conductive piezoelectric film into a device. When the thickness of the third transparent coating layer 5 is in the above-mentioned range, it is possible to obtain the transparent conductive piezoelectric film 12 having improved transparency.

### Device

A device according to one embodiment of the present invention includes the transparent conductive piezoelectric film according to the embodiment described above. The device may be any device, as long as the device includes the transparent conductive piezoelectric film according to the present embodiment. For example, a position and number of the transparent conductive piezoelectric film can be appropriately determined in accordance with the application or a desired function of the device.

The transparent conductive piezoelectric film according to one embodiment has suitable conductivity and a high piezoelectric constant, as described above. Each layer of the transparent conductive piezoelectric film can be formed by making the material of each layer in a form of ink and coating or printing the material in the form of ink. Furthermore, the transparent conductive piezoelectric film according to one embodiment has chemical stability and film flexibility. By utilizing these characteristics, the application of the transparent conductive piezoelectric film according to one embodiment to a device such as a sensor having flexibility including a pressure sensor and a vibration sensor, an energy harvesting element, and an actuator is being studied. The transparent conductive piezoelectric film according to one embodiment of the present invention is particularly preferably applied to a touch panel or the like, from the viewpoint of its conductivity and piezoelectric properties.

When the transparent conductive piezoelectric film according to one embodiment is applied to a device, in the production of the device, a transparent adhesive sheet may be formed not only on any one of the transparent coating layers, but also on another layer that adheres to the transparent coating layer via a transparent adhesive sheet. In this case, a transparent adhesive sheet layer may or may not be present on the transparent coating layer side.

In a device incorporating the transparent conductive piezoelectric film according to one embodiment, the transparent conductive piezoelectric film also functions as an electrode. Therefore, it is possible to eliminate the electrode layer that is included in known devices and made of PET/ITO, for example. Thus, a layer structure of the device can be simplified compared to a known device.

### Method of Producing Transparent Piezoelectric Film

A method of producing a transparent conductive piezoelectric film will be described below using a method of producing the transparent conductive piezoelectric film 11 as an example. The method of producing the transparent conductive piezoelectric film 11 is a method of producing a laminated film in which the first transparent coating layer 2, the second transparent coating layer 3, and the transparent electrode layer 4 are stacked in this order on at least one surface of the transparent piezoelectric film 1. The production method includes a first step of producing the transparent piezoelectric film 1 forming a film having a refractive index of 1.30 or greater and less than 1.45, a second step of forming the first transparent coating layer 2 having a refractive index of 1.60 or greater and less than 1.80 on at least one surface of the transparent piezoelectric film 1, a third step of forming the second transparent coating layer 3 having a refractive index of 1.30 or greater and less than 1.50 and a thickness of 10 nm to 70 nm on the surface of the first transparent coating layer 2, and a fourth step of forming the transparent electrode layer 4 having a refractive index of 1.80 to 2.20 and a thickness of 20 nm or greater and less than 40 nm on the surface of the second transparent coating layer 3.

The first step is only required to be a step of preparing the transparent piezoelectric film 1, and the step may be appropriately changed or a step may be added in accordance with the type of the transparent piezoelectric film 1 to be prepared. For example, the transparent piezoelectric film 1 can be prepared by continuously performing a step of preparing a resin film by a known method such as a casting method, a hot pressing method, or a melt extrusion method, a step of stretching the resin film, and a step of subjecting the non-polarized resin film to a polarization treatment.

The second step to the fourth step can be suitably implemented by utilizing a known coating method such as a wet coating method or a dry coating method. In general, in the wet coating method, a layer is formed by applying a material, and thus, the wet coating method is suitable for forming a layer having a large film thickness. In the dry coating method, a layer is formed by finely depositing a material, and thus, the dry coating method is suitable for forming a layer having a small film thickness. By applying a known technique in accordance with these advantages, each step from the second step to the fourth step can be suitably implemented.

The second step is a step of forming the first transparent coating layer. The second step can be implemented by a known method, and may be implemented by a wet coating method or a dry coating method, for example.

The wet coating method is particularly preferable from the viewpoint of productivity and manufacturing cost. In the second step using the wet coating method, the material of the first transparent coating layer only needs to be applied to at least one surface of the transparent piezoelectric film 1 prepared in the first step. The coating method may be a known method and is not particularly limited. The coating method is particularly preferably a wet coating method, from the viewpoint of productivity and manufacturing cost. The wet coating method can be a known method, and typical examples thereof include a roll coating method, a spin coating method, a dip coating method, and a gravure coating method. Among these methods, a method capable of continuously forming layers, such as the roll coating method and the gravure coating method, is more preferable from the viewpoint of productivity.

For example, a bar coater, a gravure coater, or the like may be used to apply the material of the first transparent coating layer 2. After the material is applied, the material may be dried under conditions of 50°C to 180°C for 0.5 to 60 minutes. Furthermore, a dried coating film of the first transparent coating layer 2 may be solidified by UV irradiation. For example, a UV irradiation apparatus may be used to irradiate the first transparent coating layer 2 with UV light having a cumulative light amount of 50 to 1200 mJ/cm², to solidify the first transparent coating layer 2. An apparatus, a concentration of the material, and conditions such as a temperature used in the second step may be appropriately changed with reference to the material, the film thickness, and the like of the first transparent coating layer 2.

In the second step using the dry coating method, the material of the first transparent coating layer may be deposited by a known dry coating method on at least one surface of the transparent piezoelectric film 1 prepared in the first step. Typical examples of the dry coating method include a sputtering method, a vacuum deposition method, and an ion plating method. These methods may be appropriately selected in accordance with the required film thickness.

For example, when the sputtering method is employed in the second step, examples of the target material include a metal constituting the first transparent coating layer. The target material can be appropriately selected from known target materials, in accordance with a desired refractive index of the first transparent coating layer. Examples of a sputtering gas include an inert gas such as Ar. In addition, a reactive gas, such as oxygen gas, can be used in combination as necessary.

The third step is a step of forming the second transparent coating layer. In the third step, a coating film of the material of the second transparent coating layer 3 is only required to be applied by a known method to the first transparent coating layer 2 prepared in the second step. For example, similarly to the first transparent coating layer 2, the material of the second transparent coating layer 3 may be applied by using a wet coating method. Depending on the material of the second transparent coating layer 3, it is also possible to form the coating film by a dry coating method such as a sputtering method. Conditions such as an apparatus, a concentration of the material, and a temperature in the third step may be the same as those in the second step. The film thickness of the second transparent coating layer 3 can be adjusted by adjusting the concentration of the material or the sputtering time.

The fourth step is a step of forming the transparent electrode layer. In the fourth step, it is only required that the transparent electrode layer 4 is formed by a known method on the second transparent coating layer 3 prepared in the third step. For forming the transparent electrode layer 4, it is only required that the material of the transparent electrode layer 4 is deposited by a method such as a sputtering method, a vacuum deposition method, or an ion plating method, for example. Furthermore, in the formation of the transparent electrode layer 4, similarly to the first transparent coating layer 2 and the second transparent coating layer 3, the material of the transparent electrode layer may be applied by using a wet coating method.

The fourth step will be described in more detail below by using, as an example, a configuration in which the transparent electrode layer is formed by employing a sputtering method in the fourth step. When the sputtering method is employed, examples of the target material include the above-mentioned inorganic materials constituting the transparent electrode layer 4, and preferably include ITO. The concentration of tin oxide in ITO is, for example, 0.5 mass% or greater, and preferably 2 mass% or greater, and further, for example, 15 mass% or less, preferably 13 mass% or less, and more preferably 7 mass% or less.

Examples of a sputtering gas include an inert gas such as Ar. In addition, a reactive gas such as oxygen gas, can be used in combination as necessary. When a reactive gas is used in combination, the flow rate ratio of the reactive gas is not particularly limited and is, for example, 0.1 flow rate% or more and 5 flow rate% or less relative to a total flow rate ratio of the sputtering gas and the reactive gas.

The atmospheric pressure during sputtering is, for example, 1 Pa or less and preferably 0.7 Pa or less, in order to suppress a reduction in the sputtering rate and obtain stable discharge, and the like.

The power supply used in the sputtering method may be, for example, any of a DC power supply, an AC power supply, an MF power supply, and an RF power supply, or alternatively may be a combination of these.

The production method of the present embodiment may further include another step, as long as the production method includes the first step to the fourth step. For example, the third transparent coating layer 5 may be formed on the transparent piezoelectric film 1 between the first step and the second step. The third transparent coating layer 5 may be formed by applying through a known method the material of the third transparent coating layer 5 onto the transparent piezoelectric film 1 prepared in the first step.

A step of adding another layer configuration to the transparent conductive piezoelectric film 11 may be added. Furthermore, a step of treating the transparent piezoelectric film 1 by a corona treatment to increase adhesion to the first transparent coating layer 2 may be added.

According to the production method of the present embodiment, it is possible to produce the transparent conductive piezoelectric film 11 having high transparency and a suitable color tone.

In the production method of the present embodiment, it is not necessary to implement an annealing treatment of the transparent electrode layer 4 after the fourth step. If the annealing treatment is not performed, the color tone of the transparent piezoelectric film 1 is not impaired. Therefore, it is possible to prepare the transparent conductive piezoelectric film 11 that can be suitably used for a device such as a display.

The present invention is not limited to the embodiments described above, and may be variously modified within the scope indicated in the claims. Embodiments obtained by appropriately combining technical means disclosed in different embodiments are also included in the technical scope of the present invention.

### Recapitulation

The present invention may be embodied as follows.

A transparent piezoelectric film according to a first aspect has a transmittance at a wavelength of 450 nm of 75% or greater, a transmittance at a wavelength of 550 nm of 85% or greater, and a piezoelectric constant d₃₃ of 5 pC/N to 40 pC/N, and includes a transparent electrode layer, and the transparent electrode layer has a surface resistance value of 50 Ω/sq or greater and less than 300 Ω/sq. Such a transparent conductive piezoelectric film has excellent piezoelectric properties, transparency, and conductivity, and can be suitably used in a wide range of devices.

A transparent conductive piezoelectric film according to a second aspect is the transparent conductive piezoelectric film according to the first aspect, in which a first transparent coating layer, a second transparent coating layer, and a transparent electrode layer are stacked in this order on at least one surface of a piezoelectric film, the transparent piezoelectric film has a refractive index of 1.30 or greater and less than 1.45, the first transparent coating layer has a refractive index of 1.60 or greater and less than 1.80, the second transparent coating layer has a refractive index of 1.30 or greater and less than 1.50, and the transparent electrode layer has a refractive index of 1.80 to 2.20. According to such a configuration, preferable transparency can be imparted to the transparent conductive piezoelectric film.

A transparent conductive piezoelectric film according to a third aspect is the transparent conductive piezoelectric film according to the second aspect, in which a third transparent coating layer having a refractive index of 1.45 or greater and less than 1.60 is further provided between the transparent piezoelectric film and the first transparent coating layer, the first transparent coating layer has a thickness of 60 nm to 300 nm, the second transparent coating layer has a thickness of 10 nm to 70 nm, and the transparent electrode layer has a thickness of 20 nm or greater and less than 40 nm. According to such a configuration, preferable transparency and electrical characteristics (surface resistance value) can be imparted to the transparent conductive piezoelectric film.

A transparent conductive piezoelectric film according to a fourth aspect is the transparent conductive piezoelectric film according to the third aspect, in which the third transparent coating layer, the first transparent coating layer, the second transparent coating layer, and the transparent electrode layer are stacked in this order on one surface of the transparent piezoelectric film, and another one of the third transparent coating layer is provided on the other surface of the transparent piezoelectric film. According to such a configuration, the transparency of the transparent conductive piezoelectric film can be improved.

A transparent conductive piezoelectric film according to a fifth aspect is the transparent conductive piezoelectric film according to the second aspect, in which the first transparent coating layer has a thickness of 400 nm to 1000 nm, the second transparent coating layer has a thickness of 10 nm to 70 nm, and the transparent electrode layer has a thickness of 20 nm or greater and less than 40 nm. According to such a configuration, preferable transparency and electrical characteristics (surface resistance value) can be imparted to the transparent conductive piezoelectric film.

A transparent conductive piezoelectric film according to a sixth aspect is the transparent conductive piezoelectric film according to the fifth aspect, in which the first transparent coating layer, the second transparent coating layer, and the transparent electrode layer are stacked in this order on one surface of the transparent piezoelectric film, the transparent conductive piezoelectric film includes another third transparent coating layer on the other surface of the transparent piezoelectric film, and the third transparent coating layer has a refractive index of 1.45 or greater and less than 1.60. According to such a configuration, the transparency of the transparent conductive piezoelectric film can be improved.

A transparent conductive piezoelectric film according to a seventh aspect is the transparent conductive piezoelectric film according to any one of the first to sixth aspects, in which the transparent piezoelectric film contains a fluororesin as a main component. According to such a configuration, a transparent piezoelectric film having a preferable refractive index can be obtained.

A transparent conductive piezoelectric film according to an eighth aspect is the transparent conductive piezoelectric film according to any one of the first to seventh aspects, in which the transparent electrode layer has a refractive index of 1.94 or less. Such a transparent conductive piezoelectric film is a film produced without heating at a high temperature, which is preferable in that the color tone of the transparent piezoelectric film is not impaired.

A touch panel according to a ninth aspect is a touch panel including the transparent conductive piezoelectric film according to any one of the first to eighth aspects.

A method of producing a transparent conductive piezoelectric film according to a tenth aspect is a method of producing a laminated film in which a first transparent coating layer, a second transparent coating layer, and a transparent electrode layer are stacked in this order on at least one surface of a transparent piezoelectric film, the method including a first step of producing the transparent piezoelectric film forming a film having a refractive index of 1.30 or greater and less than 1.45, a second step of forming the first transparent coating layer having a refractive index of 1.60 or greater and less than 1.80 on at least one surface of the transparent piezoelectric film, a third step of forming the second transparent coating layer having a refractive index of 1.30 or greater and less than 1.50 and a thickness of 10 nm to 70 nm on a surface of the first transparent coating layer, and a fourth step of forming the transparent electrode layer having a refractive index of 1.80 to 2.20 and a thickness of 20 nm or greater and less than 40 nm on a surface of the second transparent coating layer.

### EXAMPLES

Examples of the present invention will be described below.

### Method of Producing Transparent Conductive Piezoelectric Film

### Example 1

### First Step: Preparation of Transparent Piezoelectric Film

A resin film (thickness 120 µm) formed from polyvinylidene fluoride (available from Kureha Corporation) having an inherent viscosity of 1.3 dl/g was stretched in a stretching ratio of 4.2 times. After the film was stretched, the film was passed through a polarization roll for a polarization treatment, to obtain a piezoelectric film. Here, the polarization treatment was performed by applying a DC voltage while the DC voltage was increased from 0 kV to 12.0 kV. After the polarization treatment, the film was further heated at 130°C for 1 minute, to obtain a transparent piezoelectric film having a refractive index of 1.42 and a thickness of 40 µm.

### Second Step: Formation of First Transparent Coating Layer

An amorphous silica-containing ultraviolet-curable resin composition including an acrylic resin was applied onto an upper surface (surface A) of the transparent piezoelectric film. The obtained product was dried at 80°C, and then irradiated with ultraviolet rays having a cumulative light amount of 400 mJ/cm², to form a third transparent coating layer (thickness 1000 nm, refractive index 1.52). Next, the third transparent coating layer (thickness 1000 nm, refractive index 1.52) was also formed on a lower surface (surface B) of the transparent piezoelectric film by a similar method. Subsequently, an ultraviolet-curable resin composition containing zirconium oxide particles was applied onto an upper surface of the third transparent coating layer (surface A). The obtained product was dried at 80°C, and then, irradiated with ultraviolet rays having a cumulative light amount of 400 mJ/cm² to form a first transparent coating layer (thickness 99 nm, refractive index 1.65).

### Third Step: Formation of Second Transparent Coating Layer

A hollow silica-containing ultraviolet-curable resin composition including an acrylic resin was applied onto the first transparent coating layer. The obtained product was dried at 80°C, and then irradiated with ultraviolet rays having a cumulative light amount of 400 mJ/cm², to form a second transparent coating layer (thickness 44 nm, refractive index 1.37).

### Fourth Step: Formation of Transparent Electrode Layer

Next, an ITO film having a refractive index of 1.88 and a thickness of 30 nm was formed as a transparent electrode layer on the second transparent coating layer by a reactive sputtering method using, as a target, a sintered compact material containing 97 mass% of indium oxide and 3 mass% of tin oxide. Thus, a transparent conductive piezoelectric film was obtained, and the obtained transparent conductive piezoelectric film was used as Example 1.

### Example 2

A transparent conductive piezoelectric film was obtained similarly to Example 1, except that the thickness of the second transparent coating layer was 61 nm. The obtained transparent conductive piezoelectric film was used as Example 2.

### Example 3

A transparent conductive piezoelectric film was obtained similarly to Example 1, except that the refractive index of the first transparent coating layer was 1.70, the thickness of the first transparent coating layer was 105 nm, the refractive index of the second transparent coating layer was 1.40, and the thickness of the second transparent coating layer was 20 nm. The obtained transparent conductive piezoelectric film was used as Example 3.

### Example 4

The third transparent coating layer was not formed on the surface A and the surface B of the transparent piezoelectric film, and the first transparent coating layer, the second transparent coating layer, and the transparent electrode layer were formed in this order on the surface A of the transparent piezoelectric film. A transparent conductive piezoelectric film was obtained similarly to Example 3, except that the thickness of the first transparent coating layer was 533 nm and the thickness of the second transparent coating layer was 69 nm. The obtained transparent conductive piezoelectric film was used as Example 4.

### Example 5

A transparent conductive piezoelectric film was obtained similarly to Example 3, except that the thickness of the first transparent coating layer was 219 nm, the refractive index of the first transparent coating layer was 1.74, and the thickness of the second coating layer was 34 nm. The obtained transparent conductive piezoelectric film was used as Example 5.

### Example 6

A transparent conductive piezoelectric film was obtained similarly to Example 1, except that the thickness of the transparent electrode layer was 22 nm. The obtained transparent conductive piezoelectric film was used as Example 6.

### Example 7

A transparent conductive piezoelectric film was obtained similarly to Example 1, except that the thickness of the transparent electrode layer was 34 nm. The obtained transparent conductive piezoelectric film was used as Example 7.

### Example 8

### Formation of First Transparent Coating Layer

A third transparent coating layer was formed on both surfaces of the transparent piezoelectric film by a similar method as in Example 1, and a first transparent coating layer (thickness 83 nm, refractive index 1.65) was further formed on the surface A.

### Formation of Second Transparent Coating Layer

Next, a SiO₂ film was formed on the first transparent coating layer by a sputtering method using Si as a target material. Specifically, a chamber was evacuated to 7 x 10⁻⁴ Pa or less. Afterwards, a mixed gas of Ar gas and oxygen gas was introduced into the chamber and a SiO₂ film having a thickness of 25 nm was deposited to form a second transparent coating layer (thickness 25 nm, refractive index 1.46).

### Formation of Transparent Electrode Layer

A transparent electrode layer was formed on the second transparent coating layer similarly to Example 1. Thus, a transparent conductive piezoelectric film was obtained, and the obtained transparent conductive piezoelectric film was used as Example 8.

### Example 9

A transparent conductive piezoelectric film was obtained similarly to Example 8, except that the thickness of the first transparent coating layer was 99 nm. The obtained transparent conductive piezoelectric film was used as Example 9.

### Example 10

A transparent conductive piezoelectric film was obtained similarly to Example 8, except that the thickness of the first transparent coating layer was 139 nm. The obtained transparent conductive piezoelectric film was used as Example 10.

### Example 11

A transparent conductive piezoelectric film was obtained similarly to Example 8, except that the thickness of the first transparent coating layer was 105 nm and the refractive index of the first transparent coating layer was 1.70. The obtained transparent conductive piezoelectric film was used as Example 11.

### Comparative Example 1

A conductive piezoelectric film was obtained similarly to Example 1, except that the third transparent coating layer, the first transparent coating layer, and the second transparent coating layer were not formed. The obtained conductive piezoelectric film was used as Comparative Example 1.

### Comparative Example 2

A conductive piezoelectric film was obtained similarly to Example 1, except that the thickness of the second transparent coating layer was 80 nm. The obtained conductive piezoelectric film was used as Comparative Example 2.

### Comparative Example 3

A conductive piezoelectric film was obtained similarly to Example 2, except that the thickness of the second transparent coating layer was 151 nm. The obtained conductive piezoelectric film was used as Comparative Example 3.

### Comparative Example 4

A conductive piezoelectric film was obtained similarly to Example 1, except that the thickness of the transparent electrode layer was 45 nm. The obtained conductive piezoelectric film was used as Comparative Example 4.

### Comparative Example 5

A conductive piezoelectric film was obtained similarly to Example 1, except that the thickness of the first transparent coating layer was 100 nm, the refractive index of the first transparent coating layer was 1.52, the thickness of the second transparent coating layer was 80 nm, and the refractive index of the second transparent coating layer was 1.40. The obtained conductive piezoelectric film was used as Comparative Example 5.

### Comparative Example 6

A conductive piezoelectric film was obtained similarly to Example 1, except that the thickness of the first transparent coating layer was 105 nm, the thickness of the second transparent coating layer was 29 nm, and the refractive index of the second transparent coating layer was 1.51. The obtained conductive piezoelectric film was used as Comparative Example 6.

### Comparative Example 7

A conductive piezoelectric film was obtained similarly to Example 1, except that the thickness of the transparent electrode layer was 15 nm. The obtained conductive piezoelectric film was used as Comparative Example 7.

### Comparative Example 8

A conductive piezoelectric film was obtained similarly to Example 8, except that the thickness of the first transparent coating layer was 40 µm, the refractive index of the first transparent coating layer was 1.55, the thickness of the second transparent coating layer was 40 µm, and sputtering was performed using indium oxide containing 36 mass% of tin oxide as a target. The obtained conductive piezoelectric film was used as Comparative Example 8.

### Thickness Measurement of Each Layer

The thicknesses of the transparent coating layers and the transparent electrode layers constituting the transparent conductive piezoelectric films and the conductive piezoelectric films (hereinafter, also simply referred to as "conductive piezoelectric films") of Examples 1 to 11 and Comparative Examples 1 to 8 were determined by the method described below in which the thickness is observed by using an electron microscope. In the method, first, the transparent conductive piezoelectric film was embedded in an epoxy resin, and the epoxy resin mass was cut to expose a cross section of the transparent conductive piezoelectric film. The exposed cross-section of the transparent conductive piezoelectric film was observed using a scanning electron microscope ("SU3800", available from Hitachi High-Tech Corporation) under the conditions of an acceleration voltage of 3.0 kV and a magnification of 50000 times. The thickness of the transparent conductive piezoelectric film and the individual films or layers in the transparent conductive piezoelectric film is measured.

The refractive index of each layer in the conductive piezoelectric films of Examples 1 to 11 and Comparative Examples 1 to 8 is listed in Table 1.

### [Table 1]

**Table 1**

| | Refractive index | | | | |
|---|---|---|---|---|---|
| | Transparent piezoelectric film | Third transparent coating layer | First transparent coating layer | Second transparent coating layer | Transparent electrode layer |
| Example 1 | 1.42 | 1.52 | 1.65 | 1.37 | 1.88 |
| Example 2 | 1.42 | 1.52 | 1.65 | 1.37 | 1.88 |
| Example 3 | 1.42 | 1.52 | 1.70 | 1.40 | 1.88 |
| Example 4 | 1.42 | - | 1.70 | 1.40 | 1.88 |
| Example 5 | 1.42 | 1.52 | 1.74 | 1.40 | 1.88 |
| Example 6 | 1.42 | 1.52 | 1.65 | 1.37 | 1.88 |
| Example 7 | 1.42 | 1.52 | 1.65 | 1.37 | 1.88 |
| Example 8 | 1.42 | 1.52 | 1.65 | 1.46 | 1.88 |
| Example 9 | 1.42 | 1.52 | 1.65 | 1.46 | 1.88 |
| Example 10 | 1.42 | 1.52 | 1.65 | 1.46 | 1.88 |
| Example 11 | 1.42 | 1.52 | 1.70 | 1.46 | 1.88 |
| Comparative Example 1 | 1.42 | - | - | - | 1.88 |
| Comparative Example 2 | 1.42 | 1.52 | 1.65 | 1.37 | 1.88 |
| Comparative Example 3 | 1.42 | 1.52 | 1.65 | 1.37 | 1.88 |
| Comparative Example 4 | 1.42 | 1.52 | 1.65 | 1.37 | 1.88 |
| Comparative Example 5 | 1.42 | 1.52 | 1.52 | 1.40 | 1.88 |
| Comparative Example 6 | 1.42 | 1.52 | 1.65 | 1.51 | 1.88 |
| Comparative Example 7 | 1.42 | 1.52 | 1.65 | 1.37 | 1.88 |
| Comparative Example 8 | 1.42 | - | 1.55 | 1.46 | 1.95 |

The thickness of each layer in the conductive piezoelectric films of Examples 1 to 11 and Comparative Examples 1 to 8 is listed in Table 2.

### [Table 2]

**Table 2**

| | Thickness | | | | |
|---|---|---|---|---|---|
| | Transparent piezoelectric film | Third transparent coating layer | First transparent coating layer | Second transparent coating layer | Transparent electrode layer |
| | (µm) | (nm) | (nm) | (nm) | (nm) |
| Example 1 | 40 | 1000 | 99 | 44 | 30 |
| Example 2 | 40 | 1000 | 99 | 61 | 30 |
| Example 3 | 40 | 1000 | 105 | 20 | 30 |
| Example 4 | 40 | - | 533 | 69 | 30 |
| Example 5 | 40 | 1000 | 219 | 34 | 30 |
| Example 6 | 40 | 1000 | 99 | 44 | 22 |
| Example 7 | 40 | 1000 | 99 | 44 | 34 |
| Example 8 | 40 | 1000 | 83 | 25 | 30 |
| Example 9 | 40 | 1000 | 99 | 25 | 30 |
| Example 10 | 40 | 1000 | 139 | 25 | 30 |
| Example 11 | 40 | 1000 | 105 | 25 | 30 |
| Comparative Example 1 | 40 | - | - | - | 30 |
| Comparative Example 2 | 40 | 1000 | 99 | 80 | 30 |
| Comparative Example 3 | 40 | 1000 | 99 | 151 | 30 |
| Comparative Example 4 | 40 | 1000 | 99 | 44 | 45 |
| Comparative Example 5 | 40 | 1000 | 100 | 80 | 30 |
| Comparative Example 6 | 40 | 1000 | 105 | 29 | 30 |
| Comparative Example 7 | 40 | 1000 | 99 | 44 | 15 |
| Comparative Example 8 | 40 | - | 40 | 40 | 30 |

### Evaluation

For the conductive piezoelectric films of Examples 1 to 11 and Comparative Examples 1 to 8, physical properties and optical characteristics of the films were evaluated.

### Evaluation of Physical Properties

### Surface Resistance Value

The surface resistance value (Ω/sq) of each of the conductive piezoelectric films of Examples 1 to 11 and Comparative Examples 1 to 8 was measured in conformity with JIS K 7194 using a resistivity meter ("Loresta-GP MCP-T610", available from Mitsubishi Chemical Analytech Co., Ltd.). The measurement was performed three times, and the average value of the three results was determined as a representative value. When the surface resistance value is 50 Ω/sq or greater and less than 480 Ω/sq, it can be assured that the film can be used without practical problems in a device such as a touch panel.

### Piezoelectric Constant d₃₃ Value

The piezoelectric constant d₃₃ of each of the conductive piezoelectric films of Examples 1 to 11 and Comparative Examples 1 to 8 was measured by using a piezoelectric constant measurement device ("PiezoMeter System PM300", available from PIEZOTEST Co., Ltd.), in which the sample was clipped at 0.2 N and a generated charge was read when a force of 0.15 N and 110 Hz was applied. The actual measurement value of the piezoelectric constant d₃₃ is a positive value or a negative value, depending on whether the front or back side of the film is measured, however, the absolute value is used in the present specification. When the value of the piezoelectric constant d₃₃ is from 5 pC/N to 40 pC/N, it can be assured that the film can be applied without practical problems to a device such as a touch panel.

### Evaluation of Optical Characteristics

### Transmittance

The transmittance at a wavelength of 450 nm and the transmittance at a wavelength of 550 nm of each of the conductive piezoelectric films of Examples 1 to 11 and Comparative Examples 1 to 8 were measured by using a spectrophotometer (SD 7000, available from Nippon Denshoku Industries Co., Ltd.). When the transmittance at a wavelength of 450 nm is 75% or greater, it can be assured that the film can be applied without practical problems to a device such as a touch panel, and the transmittance at a wavelength of 450 nm is more preferably 78% or greater and more preferably 80% or greater. When the transmittance at a wavelength of 550 nm is 85% or greater, it can be assured that the film can be applied without practical problems to a device such as a touch panel, and the transmittance at a wavelength of 550 nm is more preferably 87% or greater and more preferably 89% or greater.

The results of the above-described evaluations are listed in Table 3.

### [Table 3]

**Table 3**

| | Physical properties | | Optical characteristics | |
|---|---|---|---|---|
| | Surface resistance value | d₃₃ | Transmittance at 450 nm | Transmittance at 550 nm |
| | (Ω/sq) | (pC/N) | (%) | (%) |
| Example 1 | 145 | 11.4 | 82.2 | 90.2 |
| Example 2 | 138 | 11.5 | 79.1 | 88.0 |
| Example 3 | 200 | 11.2 | 87.1 | 89.7 |
| Example 4 | 267 | 14.3 | 81.1 | 86.0 |
| Example 5 | 152 | 11.4 | 83.9 | 91.3 |
| Example 6 | 259 | 13.2 | 89.6 | 93.6 |
| Example 7 | 122 | 14.0 | 75.9 | 87.3 |
| Example 8 | 227 | 11.2 | 86.0 | 89.5 |
| Example 9 | 214 | 18.6 | 84.5 | 90.0 |
| Example 10 | 215 | 11.5 | 81.1 | 89.2 |
| Example 11 | 244 | 11.7 | 81.6 | 89.2 |
| Comparative Example 1 | 142 | 11.5 | 77.1 | 83.5 |
| Comparative Example 2 | 194 | 11.4 | 74.2 | 82.8 |
| Comparative Example 3 | 123 | 11.3 | 72.7 | 88.7 |
| Comparative Example 4 | 79 | 11.4 | 50.0 | 68.2 |
| Comparative Example 5 | 180 | 11.7 | 76.0 | 82.5 |
| Comparative Example 6 | 259 | 11.6 | 89.3 | 83.2 |
| Comparative Example 7 | 440 | 11.4 | 90.5 | 93.9 |
| Comparative Example 8 | 260 | 11.6 | 81.3 | 84.4 |

As listed in Table 3, the conductive piezoelectric films of Examples 1 to 11 each had physical properties such that the film can be used without practical problems in a device such as a touch panel, and further had high transparency that satisfies both the transmittance at a wavelength of 450 nm and the transmittance at a wavelength of 550 nm. On the other hand, the conductive piezoelectric films of Comparative Examples 1 to 8 each did not satisfy the transmittance at a wavelength of 450 nm and the transmittance at a wavelength of 550 nm.

### INDUSTRIAL APPLICABILITY

The present invention can be utilized in a device requiring piezoelectric properties.

### REFERENCE SIGNS LIST

1 Transparent piezoelectric film
2 First transparent coating layer
3 Second transparent coating layer
4 Transparent electrode layer
5 Third transparent coating layer
11, 12 Transparent conductive piezoelectric film

## Claims

1. A transparent conductive piezoelectric film having a transmittance at a wavelength of 450 nm of 75% or greater, a transmittance at a wavelength of 550 nm of 85% or greater, and a piezoelectric constant d₃₃ of 5 pC/N to 40 pC/N and comprising a transparent electrode layer, wherein
the transparent electrode layer has a surface resistance value of 50 Ω/sq or greater and less than 300 Ω/sq.

2. The transparent conductive piezoelectric film according to claim 1, wherein
a first transparent coating layer, a second transparent coating layer, and the transparent electrode layer are stacked in this order on at least one surface of a transparent piezoelectric film,
the transparent piezoelectric film has a refractive index of 1.30 or greater and less than 1.45,
the first transparent coating layer has a refractive index of 1.60 or greater and less than 1.80,
the second transparent coating layer has a refractive index of 1.30 or greater and less than 1.50, and
the transparent electrode layer has a refractive index of 1.80 to 2.20.

3. The transparent conductive piezoelectric film according to claim 2, further comprising:
a third transparent coating layer having a refractive index of 1.45 or greater and less than 1.60 between the transparent piezoelectric film and the first transparent coating layer, wherein
the first transparent coating layer has a thickness of 60 nm to 300 nm,
the second transparent coating layer has a thickness of 10 nm to 70 nm, and
the transparent electrode layer has a thickness of 20 nm or greater and less than 40 nm.

4. The transparent conductive piezoelectric film according to claim 2, wherein
the first transparent coating layer has a thickness of 400 nm to 1000 nm,
the second transparent coating layer has a thickness of 10 nm to 70 nm, and
the transparent electrode layer has a thickness of 20 nm or greater and less than 40 nm.

5. The transparent conductive piezoelectric film according to claim 3 or 4, wherein the transparent piezoelectric film comprises a fluororesin as a main component.

6. The transparent conductive piezoelectric film according to claim 3 or 4, wherein the transparent electrode layer has a refractive index of 1.94 or less.

7. The transparent conductive piezoelectric film according to claim 3, wherein
the transparent conductive piezoelectric film comprises the third transparent coating layer, the first transparent coating layer, the second transparent coating layer, and the transparent electrode layer stacked in this order on one surface of the transparent piezoelectric film, and
the transparent conductive piezoelectric film comprises another one of the third transparent coating layer on the other surface of the transparent piezoelectric film.

8. The transparent conductive piezoelectric film according to claim 4, wherein
the transparent conductive piezoelectric film comprises the first transparent coating layer, the second transparent coating layer, and the transparent electrode layer stacked in this order on one surface of the transparent piezoelectric film,
the transparent conductive piezoelectric film comprises another third transparent coating layer on the other surface of the transparent piezoelectric film, and
the third transparent coating layer has a refractive index of 1.45 or greater and less than 1.60.

9. A touch panel comprising the transparent conductive piezoelectric film described in claim 3 or 4.

10. A method of producing a transparent conductive piezoelectric film, being a method of producing a laminated film in which a first transparent coating layer, a second transparent coating layer, and a transparent electrode layer are stacked in this order on at least one surface of a transparent piezoelectric film, the method comprising:
producing the transparent piezoelectric film forming a film having a refractive index of 1.30 or greater and less than 1.45,
forming the first transparent coating layer having a refractive index of 1.60 or greater and less than 1.80 on at least one surface of the transparent piezoelectric film,
forming the second transparent coating layer having a refractive index of 1.30 or greater and less than 1.50 and a thickness of 10 nm to 70 nm on a surface of the first transparent coating layer, and
forming the transparent electrode layer having a refractive index of 1.80 to 2.20 and a thickness of 20 nm or greater and less than 40 nm on a surface of the second transparent coating layer.
